Europäisches Patentamt

European Patent Office

Office européen des brevets

(19)

(11) Publication number : **0 499 748 A1**

## (12) EUROPEAN PATENT APPLICATION

(21) Application number : 91312005.1

(22) Date of filing : 23.12.91

(51) Int. Cl.⁵ : **H01L 23/498**

(30) Priority : **27.12.90 JP 415178/90**

(43) Date of publication of application :
**26.08.92 Bulletin 92/35**

(84) Designated Contracting States :
**DE FR GB**

(71) Applicant : **International Business Machines Corporation**
**Old Orchard Road**
**Armonk, N.Y. 10504 (US)**

(72) Inventor : **Araki, Kaoru**
**1334-52, Nagahara, Yasu-cho**
**Yasu-gun, Shiga-ken 520-23 (JP)**

(74) Representative : **Mitchell, Allan Edmund et al**
**IBM United Kingdom Limited Intellectual**
**Property Department Hursley Park**
**Winchester Hampshire SO21 2JN (GB)**

(54) **TAB tape.**

(57)  A multi-layer TAB tape comprises an electrically conductive layer 1 constituting a conductor and a supporting layer 2 supporting the electrically conductive layer. Adjacent a test pad assembly 7 formed at the end of the layer 1, a slit 3 is formed in the supporting layer 2 adjacent to the part which has a large area of contact between electrically conductive layer 1 and from which the conductor is liable to be peeled off.

*FIG. 1*

EP 0 499 748 A1

The present invention relates to tape automatic bonding or TAB tapes.

In conjunction with advanced integration of semiconductors, wireless connection methods, such as TAB (tape automatic bonding) and the flip chip method, are being actively used in place of conventional wire bonding as the art for mounting semiconductor chips, because of the time required for connection and reliability.

The semiconductor chip connecting process of combined TAB technique and flip chip method, is performed with a chip with built up solder bumps mounted on a TAB tape comprised, for example, of two layers, one a support layer consisting of polyimide and the other an electrically conductive layer consisting, for example, of copper bonded thereon by sputtering or electroless plating without an intermediate bonding layer. The processing steps include, in order, reflow, washing, resin sealing, resin drying, electrical conductivity test, and lead cutting.

In the above reflow process step, however, heating at a temperature higher than 300°C can cause stress at the interface between a copper layer and a polyimide layer having different thermal expansion coefficients and can produce a peeled-off copper layer. This tendency becomes particularly great in parts where the area of contact between the polyimide layer and copper layer is large. This tendency is more remarkable at the tail end of the copper layer once it has peeled, as the control exerted by the adjacent copper layer is lost. A typical example of this is the test pad section.

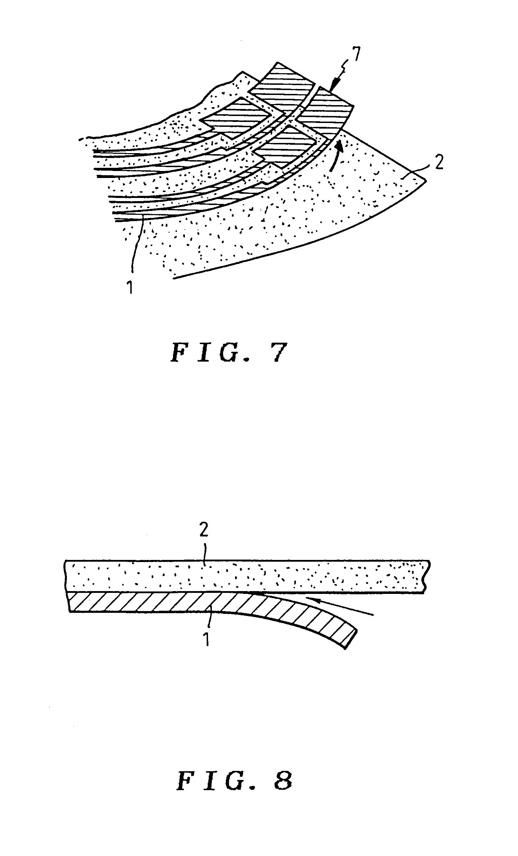

Test pad sections 7 (Figure 7) used in the electrical conductivity test, are formed at the end of a copper layer 1. No adhesive layer is interposed between the copper layer 1, from which the test pad sections 7 are formed, and polyimide layer 2, which supports copper layer 1. The end of the copper layer 1 is liable to peel off (as shown) and the test pad sections 7 are raised up and warped in a direction separating them from the polyimide layer 2, due to the thermal stress produced in the interface.

Test pad sections thus peeled off produce problems, as follows:

1. Contact failures can be caused in the electrical conductivity test process, leading to product rejection.

2. In the lead cutting process step, the mould can be broken, because of a cut-off remnant of a test pad section peeled off the polyimide layer getting caught in the cutting mould.

3. The quality of the chip circuit product itself may deteriorate, due to loss of support of the polyimide layer.

The peeling of copper layer 1 from the polyimide layer 2 caused by the difference in the thermal expansion coefficient is further advanced by external stress produced by bending Figure 8, with regard to the conductor leads formed of the copper layer 1.

Accordingly, the invention seeks to provide a TAB tape comprised of material layers having different thermal expansion coefficients and which has a structure which stops the progress of peeling in the layer interface due to thermal stress after high-temperature heating and which prevents peeling.

The invention also seeks to provide a TAB tape which has a structure which prevents the electrically conductive layer from peeling off the supporting layer with regard to the bending stress when a part of the conductor is bent to form a lead frame in the portion at a wide area of contact between the electrically conductive layer constituting the conductor and the supporting layer adjacent to it.

To solve these problems, a multi-layer TAB tape comprising an electrically conductive layer and a supporting layer supporting the electrically conductive layer, has a slit formed in the supporting layer adjacent to a part which has a large area of contact with the electrically conductive layer and from which the conductor is liable to be peeled off.

Advantageously, the slit formed with it's section tapered, so that the adhesive strength in the layer interface in the near vicinity may increase.

Preferably, the slit is formed along the outer edge of a test pad or in the supporting layer in contact with a pad section to prevent contact failure in the electrical conductivity test process.

The slit may prevent further production of peeling off of the copper layer in the wide area of contact between of the copper layer and polyimide layer.

How the invention can be carried into effect is hereinafter particularly described with reference to the accompanying drawings in which:

Figure 1 is a partial sectional view of an embodiment of TAB tape according to the invention;

Figure 2 is a partial plan view of an enlarged part of the TAB tape of Figure 1, viewed from the conductive layer side;

Figure 3 is a plan view of a further enlarged part of the TAB tape of Figure 1 viewed from the polyimide layer side;

Figure 4 is a plan view similar to Figure 2 of another embodiment of TAB tape according to the invention;

Figure 5 is a sectional view similar to Figure 2 of yet another embodiment of TAB tape according to the invention;

Figure 6 is a sectional view of the TAB tape of Figure 5 after suffering bending;

Figure 7 is a broken perspective view of part of a conventional TAB tape with a peeled test pad assembly;

and

Figure 8 is a partial sectional view of a the TAB tape of Figure 7.

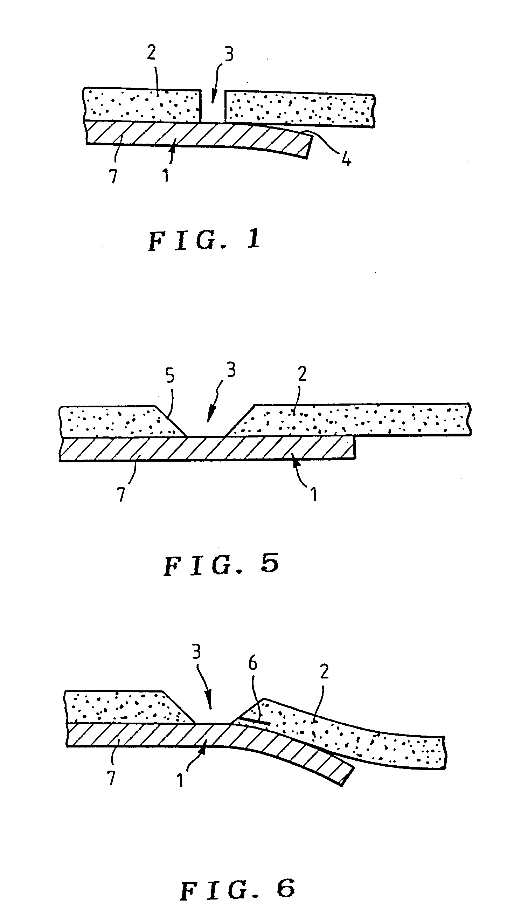

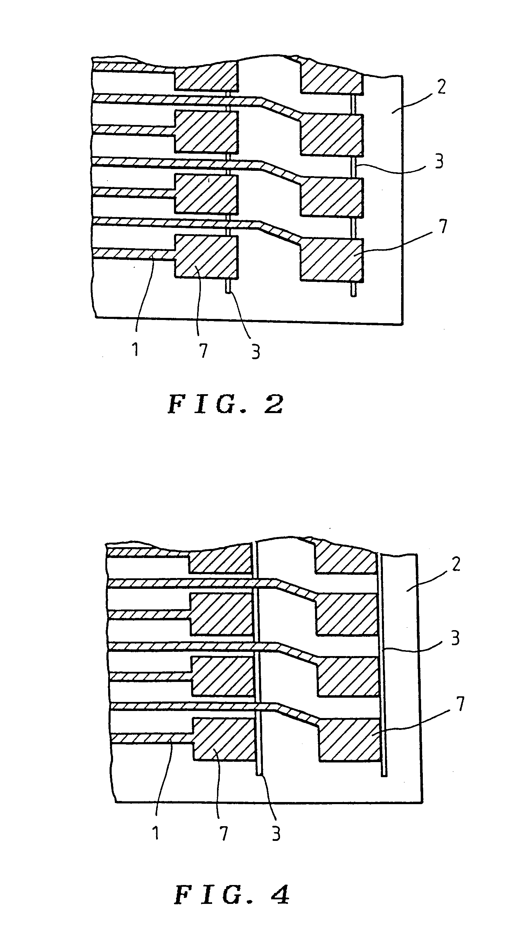

In an embodiment of TAB tape according to the invention (Figures 1 and 2), the TAB tape comprises two layers, a copper layer 1 and a polyimide layer 2. Formed of the copper layer 1 are test pad assemblies 7. There are several parts where there is contact between the copper layer 1 and the polyimide layer 2, and a slit 3 is formed in the polyimide layer 2 by a technique, such as etching, on the parts adjacent where layer 1 is liable to peel off, and particularly where the test pad assemblies 7 come into direct contact.

Conveniently, as shown in Figure 2, the slit 3 is formed as a continuous rectilinear slit just under the test pad assemblies 7. The sectional profile of the slit 3, through anisotropic etching using the RIE etching technique, for example, may be such as to have parallel side walls (Figure 1).

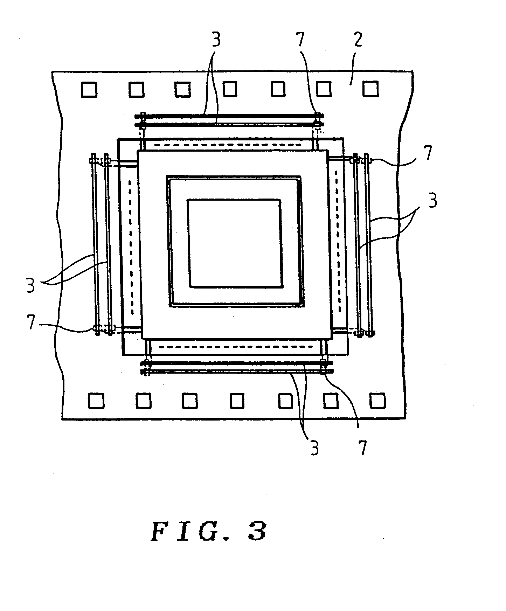

Part of the TAB tape with a chip in position is shown in Figure 3, indicating the position of formation of the slits 3 in the TAB tape, viewed from the polyimide layer 2 side.

When peeling has occurred at the end section 4 (Figure 1) of a test pad assembly 7, the part where there is peeling triggers more peeling towards the centre of the conductor leads. However, the slit 3 formed in the polyimide layer 2 in contact with the copper layer 1 can stop the progress of the peeling. The choice of sectional profile of the slit is such that a slit will satisfactorily stop the progress of peeling.

In another embodiment of TAB tape according to the invention (Figure 4), the positions at which the slits 3 are to be formed, may be along the outer ends of the test pad assemblies 7, rather than intersecting. This also can prevent peeling of the electrically conductive layer from the supporting layer, because the slits are formed on the supporting layer near the parts where the conductor is liable to be peeled off and which have a large area of contact with the conductive layer.

In yet another embodiment of TAB tape according to the invention (Figure 5), the slit 3 in the polyimide layer 2 has a tapering cross-section with inclined side walls 5 formed by chemical etching, such as plasma etching. If bending occurs on the conductor section comprised of copper layer 1 (Figure 6), the slit 3 having inclined walls 5 allows the polyimide layer 2 to follow the bending stress produced. This increases the adhesive strength of the contact section 6 between the copper layer 1 near the slit 3 and the polyimide layer 2, and prevents the separation of the copper layer 1 from the polyimide layer 2.

Table 1 shows a comparison of the peeling strength of the copper layers in TAB tapes. It shows the results of pulling the end of the copper layer using a pull gauge, of measuring the peeling strength of the copper layer, before and after reflow, on five chips mounted on TAB tape by the flip chip method with a slit formed on the taper, and on five chips using TAB tape without any slit formed.

TABLE 1

| | Cu Lead Peeling Strength (g) | | | | | |
|---|---|---|---|---|---|---|
| Sample No. | 1 | 2 | 3 | 4 | 5 | Average |
| 1-A | 16 | 95 | 112 | 121 | 89 | 106.6 |
| 1-B | 42 | 26 | 28 | 25 | 41 | 32.4 |
| 2-A | 81 | 75 | 75 | 82 | 80 | 78.6 |
| 2-B | 39 | 30 | 25 | 21 | 24 | 27.8 |
| 3-A | 35 | 49 | 37 | 46 | 33 | 40.0 |
| 3-B | 18 | 21 | 17 | 25 | 14 | 19.0 |
| 4-A | 30 | 28 | 41 | 38 | 41 | 35.6 |
| 4-B | 14 | 11 | 16 | 27 | 17 | 17.0 |

Sample Nos. 1, 2:  Before reflow

Sample Nos. 3, 4:  After reflow

Sample A        :  With slit

Sample B        :  Without slit

Whilst peeling strengths after reflow drop drastically regardless of the presence of the slit, comparison of the samples with and without the slit, shows that peeling strength in samples with the slit is about twice that of samples without the slit.

It will thus be appreciated that the invention enables the peeling strength in the interface of the material layers constituting the TAB tape to be remarkably increased, the peeling of the electrically conductive layer from the supporting layer to be prevented, and the progress of peeling to be stopped.

The described invention provides a TAB tape having a peeling preventive structure for a conductive layer which has an increased peeling strength at the interface between a plurality of material layers to prevent peeling of the conductive layer due to external stress such as thermal stress exerted in the chip mounting process and bending stress exerted in the lead frame forming process.

## Claims

1.   A multi-layer TAB tape comprising an electrically conductive layer (1) constituting a conductor and a supporting layer (2) supporting the electrically conductive layer characterised by a slit (3) formed in the supporting layer adjacent to a part which has a large area of contact with the electrically conductive layer and from which the conductor is liable to be peeled off.

2. A TAB tape according to claim 1, wherein the slit (3) is formed with its section tapered.

3. A TAB tape according to claim 1 or 2, wherein the part which has a large contact area from which the conductor is liable to be peeled off is the end section of the electrically conductive layer.

4. A TAB tape according to claim 1, 2 or 3, wherein the part which has a large contact area from which the conductor is liable to be peeled off is a test pad assembly (7).

5. A TAB tape according to claim 4, wherein the slit (3) is formed along the outer edge of the test pad assembly (7).

6. A TAB tape according to claim 5, wherein the slit (3) is formed as a continuous rectilinear slit along the outer edges of a plurality of text pad assemblies (Figure 4).

7. A TAB tape according to claim 4, wherein the slit is formed in the supporting layer in contact with the test pad assembly (7).

8. A TAB tape according to claim 7, wherein the slit (3) is formed as a continuous rectilinear slit across a plurality of test pad assemblies (Figure 2).

9. A TAB tape according to any preceding claim wherein the electrically conductive layer (1) is a copper layer.

10. A TAB tape according to any preceding claim wherein the supporting layer (2) is a polyimide layer.

FIG. 1

FIG. 5

FIG. 6

F I G. 2

F I G. 4

F I G. 3

FIG. 7

FIG. 8

EP 0 499 748 A1

**European Patent Office**

# EUROPEAN SEARCH REPORT

Application Number

EP    91 31 2005

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 15, no. 14 (E-1022)11 January 1991 & JP-A-2 263 444 ( MITSUBISHI ELECTRIC CORP ) 26 October 1990 | 1,3 | H01L23/498 |
| Y | * abstract * | 4-8 | |
| A | EP-A-0 057 253 (VDO ADOLF SHINDLING AG) * page 8, line 28 - page 9, line 9; figures 3,4,7 * | 1 | |
| Y | EP-A-0 401 848 (TOSHIBA) * column 3, line 41 - line 58; figures 2,4 * | 4-8 | |
| A | EP-A-0 368 741 (BULL SA) * column 3, line 55 - column 4, line 34; figures 1,3-5 * | 1 | |

-----

TECHNICAL FIELDS SEARCHED (Int. Cl.5)

H01L

The present search report has been drawn up for all claims

| Place of search | Date of completion of the search | Examiner |
|---|---|---|
| THE HAGUE | 14 MAY 1992 | GREENE S.K. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P0401)

10